(19) **Europäisches Patentamt**

**European Patent Office**

**Office européen des brevets**

(11) **EP 0 686 995 B1**

(12) **EUROPEAN PATENT SPECIFICATION**

(45) Date of publication and mention
of the grant of the patent:
**27.02.2002   Bulletin 2002/09**

(51) Int Cl.7: **H01J 37/317**, H01J 37/304

(21) Application number: **95304036.7**

(22) Date of filing: **12.06.1995**

(54) **An ion implantation device**

Ionenimplantierungsgerät

Appareil d'implantation inonique

(84) Designated Contracting States:
**DE FR GB IT**

(30) Priority: **10.06.1994  JP 12931994**
**05.06.1995  US 465420**

(43) Date of publication of application:
**13.12.1995   Bulletin 1995/50**

(73) Proprietor: **Axcelis Technologies, Inc.**
**Beverly, MA 01915 (US)**

(72) Inventors:
• **Hirokawa, Suguru**
**Saijyou City, Ehme-pref. (JP)**
• **Sinclair, Frank**
**Quincy, Massachusetts 02170-2112 (US)**

• **DeMario, Neil Evan**
**Ipswich, Massachusetts 01938-2128 (US)**

(74) Representative: **Burke, Steven David et al**
**R.G.C. Jenkins & Co. 26 Caxton Street**
**London SW1H 0RJ (GB)**

(56) References cited:
EP-A- 0 458 422        WO-A-91/13457
US-A- 3 778 626        US-A- 4 234 797
US-A- 4 628 209        US-A- 5 126 576

• **PATENT ABSTRACTS OF JAPAN vol. 7 no. 182
(E-192) [1327] ,11 August 1983 & JP-A-58 087746
(NIPPON DENKI) 25 May 1983,**

## EP 0 686 995 B1

**Description**

Field of the Invention

The present invention concerns an ion implantation device which implants charged particles, especially ions, into substrates such as semiconductor wafers.

Background Art

Generally, ion implantation devices of this type are used to implant ions of a predetermined chemical species into semiconductor wafers in semiconductor manufacturing processes. Furthermore, such ion implantation devices include ion implantation devices with a so-called "mechanical scanning system" in which implantation is efficiently performed by a) positioning a multiple number of semiconductor wafers around the circumference of a rotation disk, b) causing said disk to rotate so that all of the semiconductor wafers are scanned at a high speed, and c) causing relative movement of the ion beam at a comparatively low speed in the radial direction of the rotating disk, so that the individual semiconductor wafers are scanned at a low speed.

Recently, in ion implantation devices, there has been a demand for an increase in the ion beam current in order to improve the productivity of semiconductor devices by shortening the ion implantation time. Hopes have been place in the abovementioned ion implantation devices with mechanical scanning systems as ion implantation devices capable of handling such large-current ion beams.

However, in cases where a large-current ion beam is used, particles of impurities are created by sputtering which occurs as a result of parts other than the semiconductor wafers (e.g., the rotating disk) being irradiated by the ion beam. These impurity particles become mixed with the desired ions, and adhere to the semiconductor wafers, so that said semiconductor wafers become contaminated (below, this will be referred to as "contamination"). When impurity elements other than the desired ions thus become mixed with said ions and adhere to the wafers, the yield of semiconductor devices drops conspicuously.

Furthermore, it has also been indicated that in cases where the chemical species of ions being implanted is changed after certain ions have been implanted, contamination caused by the element previously being implanted (i. e., cross contamination) occurs.

Various methods have been proposed in order to prevent such contamination or cross contamination. For example, in Japanese Patent Application Kokai No. 61-116746, an ion implantation device is disclosed in which contamination caused by sputtering of the rotating disk is prevented by constructing a scanning arm assembly in which wafer attachment paddles are installed at equal intervals in a circular arrangement around a central hub, and wafers are attached to the tips of said paddles. This ion implantation device is constructed so that the scanning arm assembly is caused to rotate at high speed, and so that a cycloidal movement is performed at a low speed about the axis of the bottom part of the scanning arm assembly.

In such a construction, since wafer attachment paddles are installed as a disk, the portions of said paddles that are exposed to the ion beam can be reduced, so that the portions of the disk exposed to the ion beam can be greatly reduced; furthermore, as a result of the aforementioned cycloidal movement, the entire surface of each wafer can be irradiated with the ion beam.

However, in the abovementioned ion implantation device using wafer attachment paddles, although the speed of the aforementioned cycloidal movement is controlled so that said speed is proportional to the distance from the axis of rotation, no consideration is given to fluctuations where there are changes in the ion beam current during the aforementioned low-speed cycloidal movement, the device cannot adequately respond to said changes; as a result, ions cannot be uniformly implanted.

It is desirable to provide an ion implantation device a) which can reduce sputtering caused by exposure of the disk to the ion beam, and b) which can adequately respond to changes in the ion beam current during ion beam implantation.

Patent Abstracts of Japan vol. 7 no. 182 (E-192) [1327], 11 August 1983 & JP-A-58 087746 (Nippon Denki) 25 May 1983 disclose an ion implantation device with a wafer support having a slot and a sensor for sensing the ion beam passing through the slot.

US-A-4 234 797 also discloses an ion implantation device with a wafer support having a slot and a sensor for sensing the ion beam passing through the slot.

WO-A-91 13457 discloses an ion implantation device with ion beam sensors arranged on a wafer support.

Disclosure of the Invention

The present invention provides an apparatus for use in an ion implantation system as set out in claim 1.

In the above construction, respective ion beam charges passing between the wafers (which are separated from each other by different spacing) are successively compared over time, so that fluctuations in the ion beam current are detected. Furthermore, the speed of the aforementioned low-speed scanning in the radial direction of the disk with respect to the axis of rotation is controlled so that even if there are fluctuations in the ion beam current during ion beam implantation, ions can be implanted into the respective semiconductor wafers in a substantially uniform manner.

The invention also provides a method for use with an ion implantation system as set out in claim 7.

The invention also provides a support for use in an ion implantation system as set out in claim 10.

Brief Description of the Drawings

Figure 1 is a schematic diagram which illustrates the overall construction of the ion implantation device of an embodiment of the present invention;

Figure 2 is a plan view which illustrates the disk used (in one embodiment of the present invention) in the ion implantation device shown in Figure 1;

Figure 3 is a plan view which illustrates a modification of the disk shown in Figure 2;

Figure 4 is a plan view which illustrates the disk used in another embodiment of the present invention;

Figure 5 is a plan view which illustrates the disk used in still another embodiment of the present invention;

Figure 6 is a plan view which illustrates the disk used in still another embodiment of the present invention;

Figure 7A is a plan view which illustrates one of the semiconductor wafer attachment parts used in an embodiment of the present invention; and

Figure 7B is a sectional view as seen from the plane B-B of figure 7A.

Figure 8 is a partial schematic of the ion beam implantation system of Figure 6 showing the sequence of beam current monitoring for use in controlling speed of movement of a wafer support disk;

Figure 9 is a graph showing a function relation between charge measuresments as a function of radial location for the support disk; and

Figure 10 is a block diagram of electronic circuitry for controlling the speed of movement of the support disk shown in Figure 8.

Best Mode for Practicing the Invention

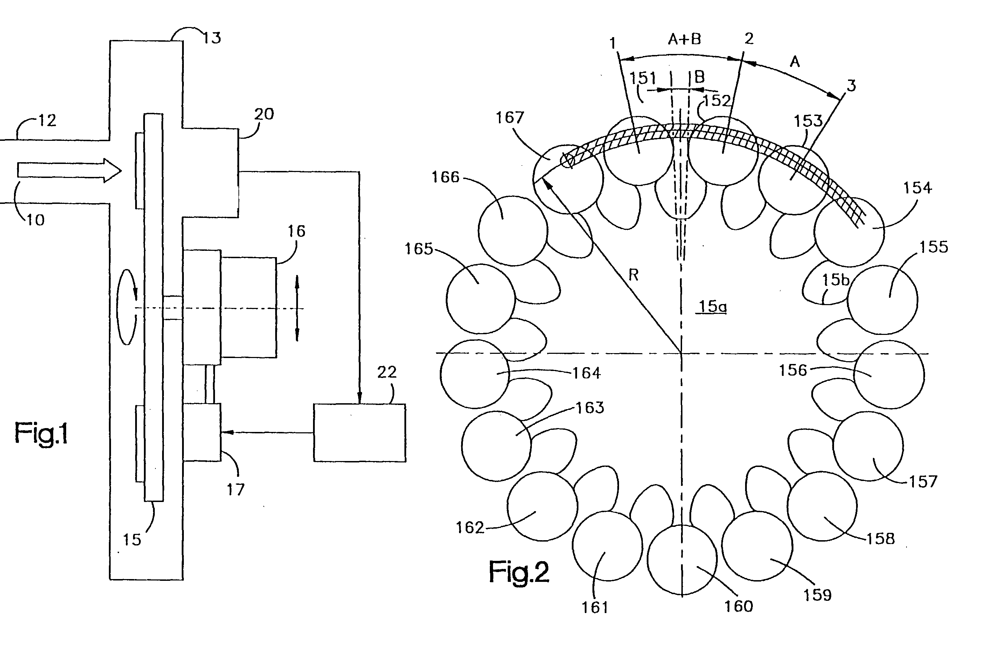

Below, an ion implantation device constituting one embodiment of the present invention will be described with reference to the attached figures. Referring to Figure 1, the ion implantation device of this embodiment has a guide chamber 12 which guides an ion beam 10 from an ion source (not shown in the figures), and a treatment chamber 13 in which the ion beam 10 from the guide chamber 12 is implanted into semiconductor wafers.

A disk 15 constructed according to an embodiment of the present invention (described in detail later) is installed inside the treatment chamber 13 shown in the figures. This disk 15 is caused to rotate at a high speed about a rotating shaft (installed at the center of said disk 15) by a high speed scanning driving mechanism 16. As a result of this rotation, the semiconductor wafers positioned around the circumference of the disk 15 are scanned at a high speed; furthermore, said wafers are also scanned at a low speed in the vertical direction in Figure 1. Accordingly, a low-speed scanning driving mechanism 17 is installed so that the individual semiconductor wafers can also be scanned at a low speed in the radial direction from the axis of rotation. Here, a mechanism whose low-speed scanning operation can be controlled is used as the aforementioned low-speed scanning driving mechanism; meanwhile, the driving mechanism used for high-speed scanning may be an ordinary driving mechanism.

A beam current measuring device referred to commonly as a Faraday cup 20 is positioned behind the disk 15 installed in the treatment chamber 13 (i.e., on the opposite side of said disk from the side irradiated by the ion beam), and the charge of the ion beam passing through the disk 15 is measured by this beam current measuring device 20. Since this beam current measuring device 20 may consist of a commonly used device, a detailed description of said device 20 is omitted here.

The abovementioned beam current measuring device 20 is connected to a control part 22; this control part 22 performs predetermined calculations based on the charge detected, and controls the scanning speed of the low-speed scanning driving mechanism 17 so that ions are uniformly implanted.

Referring now to Figure 2 as well, a multiple number of semiconductor wafer attachment parts 151-167 used for wafer attachment, i.e., 17 wafer attachment parts in the case of this embodiment (hereafter referred to collectively as 15n), are installed around the outside circumference of the disk 15 in the present embodiment, and respective semiconductor wafers are placed on each of these attachment parts 15n. Furthermore, the central part 15a of the disk 15 and the semiconductor wafer attachment parts 15n, are connected by bridge parts 15b which have a narrower width than the semiconductor wafer attachment parts 15n, so that the area of the disk 15 that is exposed to the ion beam is reduced.

Furthermore, in the example shown in the figures, the spacing between the semiconductor wafer attachment parts 151, 152 is set so that it is wider than the respective spacings between the other attachment parts (e.g. 152, 153). This means that the spacing between the semiconductor wafers attached to the attachment parts 151, 152 is wider than the respective spacings between the semiconductor wafers attached to the other attachment parts. Here, the conditions other than the aforementioned spacing, i.e. the wafer size and method of support, etc. are the same for all of the wafer attachment parts.

In the case of a disk 15 constructed as described above, the bridge parts 15b are extremely narrow; accordingly, the area exposed to the ion beam is small, so that contamination caused by exposure of the disk 15 to the ion beam can be greatly reduced.

Meanwhile, the angle between the center of the attachment part 151 and the center of the attachment part 152 can be expressed as A + B, where A is the angle between the center of the attachment part 152 and the center of the adjacent attachment part 153, and B is the angle of an additional space between the attachment parts 151, 152.

In this case, assuming that the center of the ion beam is located at a distance of R from the center of the disk 15, the area indicated by shading in Figure 2 is irradiated by the ion beam. Accordingly, the charge measured by the beam current measuring device 20 installed on the downstream side of the disk 15 while the center of the ion beam passes from the center position 1 of the attachment part 151 to the center position 2 of the attachment part 152 is measured as the charge of the ion beam passing through the gap (i.e., the spacing) between the attachment parts 151, 152. Here, the charge measured by the beam current measuring device 20 is designated as QA+B.

Next, when the charge occurring while the center of the ion beam passes from the center position 2 of the attachment part 152 to the center position 3 of the attachment part 153 is similarly measured by the beam current measuring device 120, said charge is measured as the charge passing through the gap that defines the spacing of the attachment parts 152, 153. The charge measured in this case is designated as QA.

It is seen that the charge of the beam passing through the fan-shaped portion with an angle of B can be determined by calculating QA+B-QA under the conditions described above. This means that changes in the ion beam current during ion implantation can be detected; consequently, the charge of the ions implanted into the semiconductor wafers 25 attached to the respective attachment parts 15n can be maintained at a substantially constant level by controlling the speed of movement of the disk 15 in the radial direction, i.e., the scanning speed, in accordance with the aforementioned changes. More concretely, where V is the aforementioned speed of movement in the radial direction, said movement speed V can be expressed as $V = K(QA+B-QA)/R$ (here, K is a proportionality constant). If the movement speed V is calculated by the control part 22 (shown in Figure 1) using this formula, and the low-speed scanning driving mechanism is controlled in accordance with the result obtained, ions can be uniformly implanted.

It is sufficient if the abovementioned charge measurement and control action are performed for each revolution of the disk. In such a case, any discrepancies in timing are cancelled.

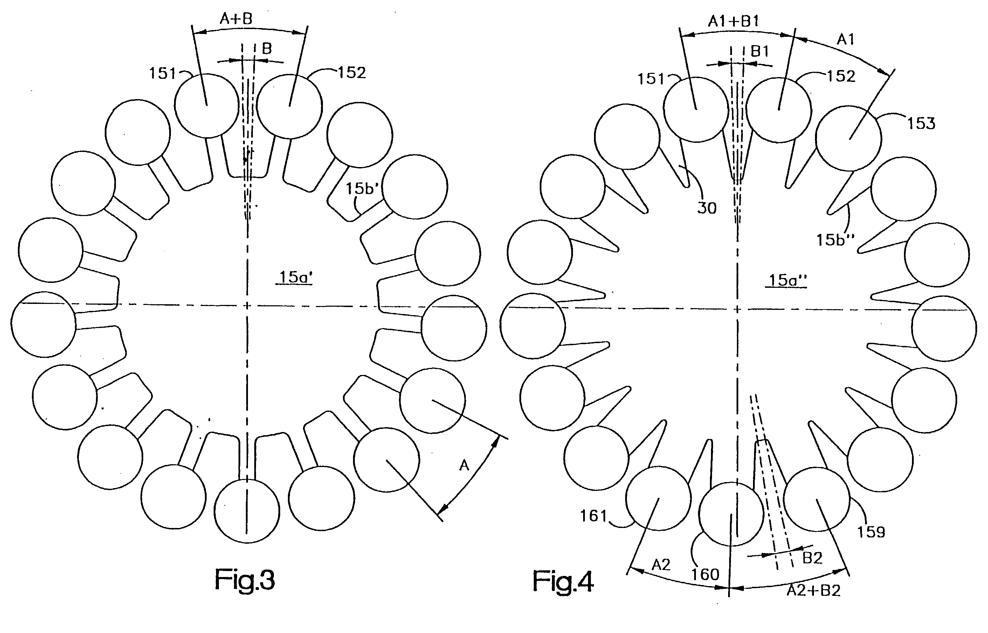

Referring to Figure 3, the disk 15 in a modification of the embodiment shown in Figure 1 differs from the disk shown in Figure 2 in that the center part 15a' of the disk and the attachment parts 15n are connected by rectangular bridge parts 15b'. As in Figure 2, two of the attachment parts installed in specified positions (attachment parts 151, 152 in Figure 3) are positioned with a spacing of angle B; as a result, the angle between the center positions of these specified attachment parts 151, 152 can be expressed as A+B, and thus different from the angle A between the center positions of the other attachment parts.

In this case, as in the case of Figure 2, the portion of the disk 15 that is exposed to the ion beam can be minimized; furthermore, the speed of movement of the disk 15 in the radial direction, i.e., the scanning speed, can be adjusted in accordance with changes in the ion beam current so that ions are uniformly implanted into the semiconductor wafers attached to the attachment parts 15n.

Referring to Figure 4, the disk in another embodiment of the present invention is constructed so that adjacent attachment parts 15n are separated from each other by notches (i.e.,valleys) 30 , with a stipulated spacing between each pair of adjacent attachment parts 15n. Here, the spacing between attachment parts 15n is substantially the same as the spacing between the semiconductor wafers. In this example, the bridge parts 15b" which connect the attachment parts 15n with the central part 15a" of the disk have a tapered shape which becomes slightly wider toward the central part 15a" of the disk.

In figure 4, the angular spacing determined by the notch between the attachment parts 151, 152 is set at B1, and the angular spacing determined by the notch between the attachment parts 159, 160 is set at B2. Meanwhile, the angular spacing between the remaining attachment parts is set at a value which is smaller than the aforementioned angular spacings B1, B2.

Furthermore, in a case where the angle between the center position of the attachment part 152 and the center position of the adjacent attachment part 153 is set at AI, and the angle between the center position of the attachment part 160 and the center position of the adjacent attachment part 161 is set to A2, the angle between the attachment parts 151, 152 can be expressed as A1 + B1, and the angle between the attachment parts 159, 160 can be expressed as A2 + B2.

In this case, as in the case of Figure 2, the charges for the angles (A1 + B1) and (A2 + B2) can be expressed as the ion beam charges QA1 + B1 and QA2 + B2 passing through the respective notches. Accordingly, the scanning speed V at various locations in the radial direction can be expressed as follows (in a case where the ion beam is located at a position of radius R):

$$V + K(QAN + BN - QAN)/R \qquad \text{(eq 1.)}$$

(Here, N indicates 1 or 2) As is also clear from the above equation, two or more notches with different angular spacings may be formed. Furthermore, the mean value of the charge may be used for the control of the scanning speed V.

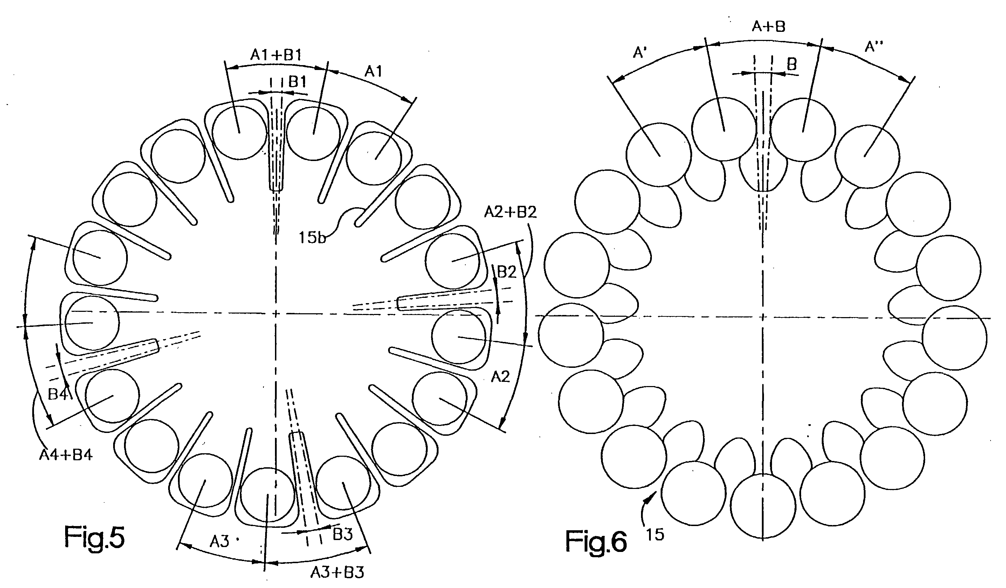

Referring to Figure 5, the disk 15 in still another embodiment of the present invention has wide notches in four places, and has tapered bridge parts 15b that widen outward in the radial direction from the central part of the disk. Furthermore, these bridge parts 15b are formed as integral units with the attachment parts 15n, and semiconductor wafers 25 are placed on said attachment parts 15n. Here, the spacings between the centers of the attachment parts adjacent to the respective wide notches are expressed by the angles A1, A2, A3 and A4. Assuming that the four notches have respective angles of B1, B2, B3, and B4, the spacings between the centers of the respective attachment parts located on either side of the wide notches can be expressed by the angles (A1 + B1), (A2 + B2), (A3 + B3) and (A4 + B4). The aforementioned equation 1 is also valid in this example; accordingly, ions can be uniformly implanted into the semiconductor wafers 25 by controlling the scanning speed V.

Referring to Figure 6, a wide notch which has an angle of B, and ordinary notches which have angles smaller than that of the wide notch, are formed in the disk 15 of still another embodiment of the present invention. In this case, the scanning speed V can be controlled using the following equation (where A is the angle between the semiconductor wafers on either side of the ordinary notches, A + B is the angle between the semiconductor wafers on either side of the wide notch, and QA(R - ∆R), QA(R + ∆R) and QA + B(R) are the charges passing through the respective notches);

$$V = K(QA+B(R) - (QA(R - \Delta R) + QA(R + \Delta R))/2)/R \qquad \text{(Eq 2.)}$$

As is clear from Equation 2 as well, the shift (∆R) in the radial position caused by low-speed scanning (which is ordinarily ignored) can be considered by subtracting the mean value of the charges passing through adjacent notches from the charge passing through the wide notch, so that ions can be implanted into the respective semiconductor wafers 25 more accurately.

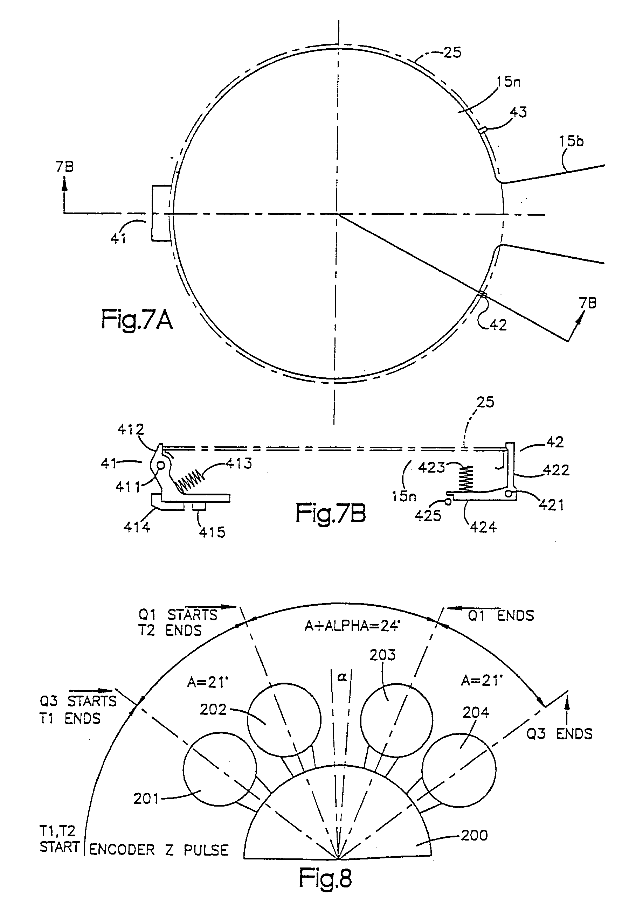

Figures 7A and 7B illustrate the construction of a clamping part used to support the semiconductor wafers on the disks of the respective embodiments of the present invention described above. As is clear from Figure 7A, a first clamp 41 which supports the semiconductor wafer 25 against the centrifugal force caused by rotation is installed on the outer circumference of each attachment part, and second and third clamps 42, 43 are installed on the inner circumference. Here, the second and third clamps 42, 43 have the same structure; accordingly, only the second clamp 42 will be described below. As is shown in Figure 7B, the first clamp 41 has a rotation shaft 411 which is fastened to the attachment part 15n, and a fastening pawl 412 which extends upward from the rotating shaft 411. This fastening pawl 412 contacts the circumference of the semiconductor wafer 25, and supports the wafer 25 so that said wafer 25 is not pushed outward by centrifugal force. Furthermore, the portion of the first clamp 41 that extends downward is fastened to the attachment part by a compression spring 413, so that said spring 413 drives the first clamp 41 in the clockwise direction in Figure 7B. Moreover, a weight 414 is attached to the portion of the first clamp 41 that extends horizontally, and a stopper 415 is installed in front of the weight 414.

Meanwhile, in the case of the second clamp 42, there is no need to consider the effects of centrifugal force. Accordingly, this clamp 42 has a simplified structure compared to that of the first clamp 41. Here, said clamp 42 is equipped with a moveable member 422 which can rotate about a rotating shaft 421 supported on the attachment part 15n, and an arm 424 which is attached to the attachment part 15n by a compression spring 423. A stopper 425 is installed at the inside edge part of the arm 424; this stopper 425 prevents the arm 424 from pivoting into an undesired position when no wafer 25 is attached.

The semiconductor wafer 25 is retained from the sides by the first through third clamps constructed as described above, so that said semiconductor wafer 25 is clamped to the surface of the attachment part 15n.

In the present embodiments, a disk which allows a plurality of wafers to be positioned at a prescribed spacing around the circumference of said disk is constructed so that there is at least one place on said disk where the spacing between wafers is different from the spacing elsewhere. As a result, the area of the disk that is exposed to the ion beam is reduced, and contamination caused by undesired sputtering can be prevented. Furthermore, fluctuations in the ion beam current are detected from the ion beam charges passing through the aforementioned areas with different spacing, and the rate of low-speed scanning is controlled in accordance with these detection results, so that ions can be uniformly implanted into the semiconductor wafers.

Turning now to Figures 8 - 10, an alternate method is disclosed for calculating the desired speed V at which the disk 15 is moved in the radial direction by the low speed scanning mechanism 17. A nominal speed of rotation for the disk 15 during ion implantation is 20 revolutions per second. The number of back and forth traversals of the disk by the low speed scanning mechanism during one implant can be selected to be in a range from a few to many hundred with 200 being representative.

If the ion beam intensity could be maintained at a constant value, determining an appropriate instantaneous speed for the low speed scanning mechanism during the back and forth traversals would be straightforward. To assure proper implantation intensity, the instantaneous speed V in a radial direction would be a constant divided by the radius or distance from the center of the spinning disk to the region on the disk the beam 10 strikes the wafers.

Variations in beam intensity are sensed by apparatus particularly suited for the wafer support structure shown in Figure 8 to control the rate at which the low speed scanning mechanism 17 moves the disk 15 back and forth in the radial direction. The instantaneous speed must by adjusted to be proportional to the instanteous beam current divided by the radius. In equation form:

$$V(instantaneous) = K(Current)/R \qquad (Eq. 3)$$

Figure 8 illustrates a partial view of a disk 200 similar to the disk 15 shown in Figure 6 in the region of four pedestals 201-204 that support four semiconductor wafers. Two pedestals 202, 203 are spaced apart by an amount that is greater than a spacing between other adjacent pedestals around the circumference of the disk. In one embodiment of the invention the increased spacing, alpha is 3 degrees. By integrating beam current from the Faraday Cup 20 during two different time intervals that both include the time interval the beam scans through the region between the two pedestals 202, 203 an accurate indication of the beam current is obtained.

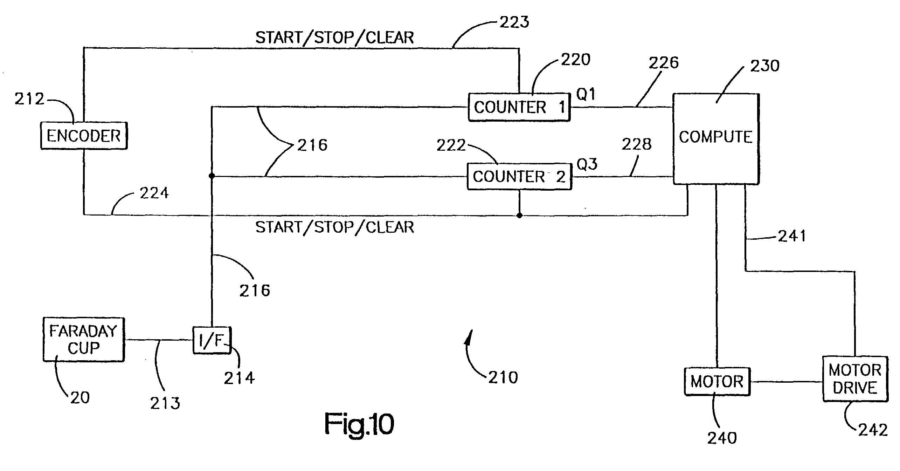

The ion implantation control 22 includes a circuit 210 (Figure 10) that includes a rotary drive encoder 212 having two timers T1, T2 that are implemented using an AMD9513 integrated circuit. An output 213 from the Faraday Cup 20 represents a signal directly proportional to beam current. When this signal is integrated over time, one has a signal proportional to the beam charge. By starting two beam current integrators at the points labeled 'Q3 starts' and 'Q1 starts' (Figure 8) and stopping the integrators at the points labeled 'Q3 ends' and 'Q1 ends', one has a measure of the charge striking the Faraday cup during two intervals that include the virtual slot alpha.

The encoder 212 monitors a timing mark and produces a timer pulse that starts two timers T1, T2 when the mark passes the encoder 212. When the timer T1 times out the beam 100 has reached the center of the wafer support 201 and a first charge monitoring interval begins. The second timing interval begins when the beam passes a center of the next wafer support 202.

The following mathematical relations govern the measured charge during the two time intervals the charge integrators are gathering data:

$$Q3 = (CONSTANT)(3A + alpha) \qquad (eq. 4)$$

$$Q1 = (CONSTANT)(A + alpha) \qquad (eq. 5)$$

where the CONSTANT is a proportionality constant and the A and alpha are the angles labeled in Figure 8 and Q3 and Q1 are charges of the ion beam striking the Faraday cup during the two charge measuring intervals. One can solve for alpha in these equations with the knowledge that the correct instantaneous speed V can be expressed as:

$$V = K(alpha)/R \qquad (eq. 6),$$

where

$$alpha = (3Q1 - Q3)/2 \qquad (eq. 7)$$

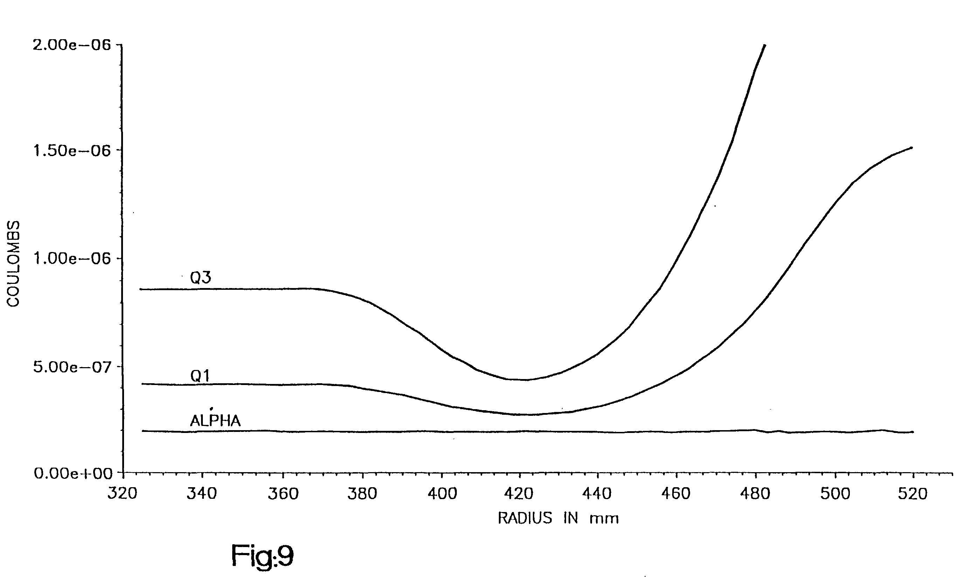

Turning to Figure 9, one sees that while both Q1 and Q3 have non-constant functional relations with respect to the radius R, alpha is a constant with respect to the radius R. The value of alpha is directly related to beam current, thus allowing the equation 6 relation to be used to control the linear scan velocity.

Figure 10 is a schematic diagram of the components of the circuit 210 used to calculate alpha on an essentially real time basis. The circuit 210 includes an input for monitoring the instantaneous current signal output 213 from the Faraday cup 20. These currents are converted by an analog-to-digital converter 214 to an oscillating signal output 216 whose frequency changes as a function of the instantaneous current sensed by the Faraday cup 20.

The signal output 216 from the analog-to-digital converter 214 is input to two counters 220, 222 having control inputs 224, 226 coupled to the encoder circuit 212. The encoder circuit 212 clears the counters 220, 222 at appropriate start times as indicated in Figure 8 and sends a stop signal at appropriate times that causes the counters to stop counting the alternating signals from the anlaog-to-digital converter 214.

Signal outputs 228, 229 from the two counters 220, 222 corrresponding to the charge striking the Faraday Cup 20 during the intervals depicted in Figure 8 are coupled to a processor 230 that calculates the valuve of alpha based on Q1 and Q3. A signal fed back from a reversible d.c. scan motor 240 is input to the processor 230 to indicate the linear scan postion and from this value a velocity output signal 241 is coupled to a motor controller 232 which causes the low speed scan mechanism to move the disk. In a preferred embodiment of the invention the low speed scan is accomplished by the reversible D.C. motor 240 that rotates a screw actuator that moves the disk back and forth along a linear travel path.

The control 22 is able to calculate the values for Q1 and Q3 in an interval of about 50 microseconds. This is fast enough that the speed of movement for the motor 240 is updated every revolution of the spinning disk.

**Claims**

1. Apparatus for use in an ion implantation system having an ion source for directing an ion beam (10) to enter an implantation chamber (13) for implanting wafers comprising:

   a support (15) for positioning within the implantation chamber, the support (15) comprising a plurality of circumferentially spaced wafer attachment parts (15a) for supporting wafers at circumferentially spaced intervals around the circumference of said support (15), the support being constructed so that there is a spacing interval between at least one pair of adjacent wafer attachment parts (15a) that is non-uniform with respect to a spacing interval between other pairs of adjacent wafer attachment parts (15a) elsewhere about the circumference;
   a motor (16) for rotating the support (15) about a rotation axis with respect to the ion beam entering the implantation chamber to cause wafers to intercept the ion beam;
   a sensor (20) disposed behind the support for monitoring ion beam current of the ion beam entering the implantation chamber that passes the support (15) and attached wafers;
   a scan device (17) for moving the support (15) along a travel path to cause an entire surface of the wafers attached to the support (15) to be treated by the ion beam; and
   a control circuit (22) for controlling movement of the support (15) along the travel path comprising a circuit for monitoring beam current during two different time intervals that include a first time interval during which the ion beam is passing through the non-uniform spacing interval and a second time interval during which the ion beam is passing through a spacing interval other than the non-uniform spacing interval, determining charge reaching the sensor during the two different time intervals, and controlling the speed of movement of the support along the travel path based on the charge sensed during the two different time intervals.

2. The apparatus of claim 1 where the control circuit (22) updates the speed of movement along the travel path during each revolution of the support.

3. The apparatus of claim 1 where the circuit for monitoring beam current includes an encoder circuit (212) for monitoring the rotation of the support and supplying timing signals related to the orientation of the support and further comprises first and second timing circuits (220;222) responsive to the encoder circuit for determining the charge during the two different time intervals.

4. The apparatus of claim 1 wherein the scan device (17) comprises a reversible electric motor (240) and linear actuator coupled to the support for moving the support along a linear travel path.

5. The apparatus of claim 3 wherein the control circuit (22) comprises means (230) for computing an instantaneous speed along the travel path that is directly proportional to a computed value that is independent of a distance R between the axis of rotation of the support and a region of contact between the ion beam and the wafers connected to the support.

6. The apparatus of claim 5 wherein the second time interval corresponds to the time for the beam to sweep from the centre of a first wafer attachment part and then across second and third wafer attachment parts spaced by the non-uniform spacing interval to the center of a fourth wafer attachment part and wherein a first time interval corresponds to the time it takes the beam to sweep across centers of the second and third wafer attachment parts and wherein the computed value is equal to the quantity $(3Q_1 - Q_3)/2$, where the value of $Q_1$ is a charge impinging on the sensor during the first time interval and the value of $Q_3$ is a charge impinging on the sensor (20) during the second time interval of said two different time intervals.

7. A method for use with an ion implantation system having a source for directing an ion beam (10) to enter an implantation chamber (13) for implanting wafers (25) comprising the steps of:

   positioning a plurality of wafers at spaced intervals around the circumference of a support (15) within the implantation chamber so that there is at least one spacing interval between a pair of adjacent wafers that is non-uniform with respect to a spacing interval between other pairs of adjacent wafers elsewhere about the circumference;
   rotating the support (15) with respect to the ion beam that enters the chamber to cause wafers pass through the ion beam;
   positioning a sensor (20) for monitoring ion beam current of the ion beam behind the support (15) to monitor ion beam current as the bean passes through spaces between wafers;
   mounting the support (15) for movement along a travel path to cause an entire surface of the wafers to be treated by the ion beam; and
   controlling movement of the support (15) along the travel path by monitoring beam current during two different time intervals including a first time interval during which the ion beam is passing through the non-uniform spacing interval and a second time interval during which the ion beam is passing through a spacing interval other than the non-uniform spacing interval, determining charge reaching the sensor during the two different time intervals, and controlling the speed of movement of the support along the travel path based on the charge sensed during the two different time intervals.

8. The method of claim 7 wherein the step of monitoring beam current and determining the charge reaching the sensor (20) during the two different time intervals is performed during each rotation of the disk for a given implantation.

9. The method of claim 7 wherein the step of controlling the speed is performed by monitoring charge during the second time interval corresponding to the time for the beam to sweep from a centre of a first wafer and then across second and third wafers spaced by the non-uniform spacing interval to a center of a fourth wafer and monitoring charge during the first time interval corresponding to the time it takes the beam to sweep across centers of the second and third wafers and computing a value of $(3Q_1 - Q_3)/2$, where the value of $Q_1$ is a charge impinging on the sensor during the first time interval and the value of $Q_3$ is a charge impinging on the sensor during the second time interval and making the instantaneous speed proportional to this quantity and inversely proportional to a distance between a rotation axis of the support (15) and a region of contact between the ion beam and the wafers attached to the support (15).

10. A support (15) for use in an ion implantation system for supporting wafers, the support comprising a plurality of radially-extending wafer attachment parts (15a) for supporting wafers at circumferentially spaced intervals around the circumference of the support (15), **characterised in that** the angle between centres of a pair of adjacent wafer attachment parts (15a) with respect to the centre of the support (15) is different from the angle between centres of other pairs of adjacent wafer attachment parts (15a) with respect to the centre of the support (15).

**Patentansprüche**

1. Vorrichtung zur Verwendung in einem Ionenimplantationssystem mit einer Ionenquelle, um einen Ionenstrahl (10) zum Eintritt in eine Implantationskammer (13) zum Implantieren von Wafern zu leiten, wobei folgendes vorgesehen ist:

   ein Träger (15) zur Positionierung innerhalb der Implantationskammer, wobei der Träger (15) eine Vielzahl von umfangsmäßig beabstandeten Waferanbringteilen (15a) aufweist, und zwar zum Tragen der Wafer an umfangsmäßig beabstandeten Intervallen, um den Umfang des Trägers (15) herum, wobei der Träger derart konstruiert ist, dass ein Abstandsintervall vorgesehen ist zwischen mindestens einem Paar benachbarter Waferanbringungsteile (15a) das nicht gleichförmig ist bezüglich eines Abstandsintervalls zwischen anderen Paaren von benachbarten Waferanbringungsteilen (15a) anderswo um den Umfang herum;

ein Motor (16) zum Drehen des Trägers (15) um eine Drehachse bezüglich des in die Implantationskammer eintretenden lonenstrahls um zu bewirken, daß die Wafer den lonenstrahl auffangen;

ein Sensor (20) angeordnet hinter dem Träger zur Überwachung des lonenstrahlstroms des in die lonenkammer eintretenden lonenstrahls der den Träger (15) und die daran befestigten Wafer passiert;

eine Abtastvorrichtung (17) zur Bewegung des Trägers (15) entlang einer Laufbahn um zu bewirken, daß eine gesamte Oberfläche der an dem Träger (15) angebrachten Wafer mit dem lonenstrahl behandelt wird; und

eine Steuerschaltung (22) zur Steuerung der Bewegung des Trägers (15) entlang der Laufbahn, und zwar folgendes aufweisend:

eine Schaltung zur Überwachung des Strahlstromes während zweier unterschiedlicher Zeitintervalle die ein erstes Zeitintervall und zweites Zeitintervall umfassen, wobei während des ersten Zeitintervalls der lonenstrahl durch das nicht gleichförmig beabstandete Intervall läuft, und wobei während des zweiten Zeitintervalls der lonenstrahl durch ein anderes als das nicht gleichförmig beabstandete Intervall läuft,

Ferner Bestimmen der den Sensor während der zwei unterschiedlichen Zeitintervalle erreichenden Ladung, und

Steuern der Bewegungsgeschwindigkeit des Trägers entlang der Laufbahn basierend auf der während der zwei unterschiedlichen Zeitintervalle abgefühlten Ladung.

2. Vorrichtung nach Anspruch 1, wobei die Steuerschaltung (22) die Bewegungsgeschwindigkeit entlang der Laufbahn während jeder Drehung des Trägers auf den neuesten Stand bringt.

3. Vorrichtung nach Anspruch 1, wobei die Schaltung zur Überwachung des Strahlstromes eine Kodierschaltung (212) aufweist zur Überwachung der Drehung des Trägers und zur Lieferung von Zeitsteuersignalen die mit der Orientierung des Trägers in Beziehung stehen, und wobei ferner erste und zweite Zeitsteuerschaltungen (220; 222) vorgesehen sind, die auf die Kodierschaltung ansprechen, um die Ladung während zweier unterschiedlicher Zeitintervalle zu bestimmen.

4. Vorrichtung nach Anspruch 1, wobei die Abtastvorrichtung (17) einen reversiblen Elektromotor (240) aufweist und einen Linearbetätiger gekuppelt mit dem Träger zur Bewegung des Trägers entlang einer linearen Laufbahn.

5. Vorrichtung nach Anspruch 3, wobei die Steuerschaltung (22) Mittel (230) aufweist, zur Berechnung einer augenblicklichen Geschwindigkeit entlang der Laufbahn die direkt proportional ist zu einem berechneten Wert, der unabhängig ist von einem Abstand R zwischen der Drehachse des Trägers und einer Kontaktregion oder Kontaktzone zwischen dem lonenstrahl und den mit dem Träger verbundenen Wafern.

6. Vorrichtung nach Anspruch 5, wobei das zweite Zeitintervall der Zeit entspricht die der Strahl benötigt, um eine Überstreichung vorzunehmen von der Mitte eines ersten Waferanbringungs- oder -befestigungsteils und so dann über zweite und dritte Waferbestigungsteile beabstandet durch das nicht gleichförmige Abstandsintervall zur Mitte eines vierten Waferanbringungs- oder Befestigungsteils, und wobei ein erstes Zeitintervall der Zeit entspricht, die der Strahl braucht, um eine Überstreichung vorzunehmen über die Mitten der zweiten und dritten Waferbefestigungsteile, und wobei der berechnete Wert gleich der Größe (3Q1-Q3)/2 ist, wobei der Wert Q1 eine Ladung ist, die auf den Sensor während des ersten Zeitintervalls auftrifft, und wobei der Wert von Q3 eine Ladung ist, die auf den Sensor (20) während des zweiten Zeitintervalls der zwei unterschiedlichen Zeitintervalle auftrifft.

7. Verfahren zur Verwendung bei einen lonenimplantationssystem mit einer Quelle um einen lonenstrahl (10) zum Eintritt in eine Implantationskammer (13) zum Implantieren von Wafern (25) zu leiten, wobei die folgenden Schritte vorgesehen sind:

Positionieren einer Vielzahl von Wafern an beabstandeten Intervallen um den Umfang eines Trägers (15) herum, und zwar innerhalb der Implantationskammer derart, daß mindestens ein Abstandsintervall zwischen einem Paar von benachbarten Wafern nicht gleichförmig ist bezüglich eines Abstandsintervalls zwischen anderen Paaren von benachbarten Wafern anderswo um den Umfang herum;

Drehen des Trägers (15) bezüglich des lonenstrahls, der in die Kammer eintritt, um zu bewirken, dass Wafer

durch den Ionenstrahl laufen;

Positionieren eines Sensors (20) zur Überwachung des Ionenstrahlstromes des Ionenstrahls hinter dem Träger (15) um den Ionenstrahlstrom zu überwachen, wenn der Strahl durch die Abstände zwischen den Wafern läuft;

Anbringung des Trägers (15) für eine Bewegung entlang einer Laufbahn, um zu bewirken, daß eine gesamte Oberfläche der Wafer durch den Ionenstrahl behandelt wird; und

Steuerung der Bewegung des Trägers (15) entlang der Laufbahn durch Überwachen des Strahlstromes während zwei unterschiedlicher Zeitintervalle einschließlich eines ersten Zeitintervalls während dessen der Ionenstrahl durch das nicht gleichförmige Abstandsintervall läuft und eines zweiten Zeitintervalls während welchem der Ionenstrahl durch ein anderes Abstandsintervalls als das nicht gleichförmige Abstandsintervall läuft,

Bestimmen der den Sensor während zwei unterschiedlicher Zeitintervalle erreichenden Ladung, und

Steuern der Bewegungsgeschwindigkeit des Trägers entlang der Laufbahn basierend auf der während der zwei unterschiedlichen Zeitintervalle abgefühlten Ladung.

8. Verfahren nach Anspruch 7, wobei der Schritt des Überwachens des Strahlstromes und der Bestimmung der Ladung die den Sensor (20) während zwei unterschiedlicher Intervalle erreicht, ausgeführt wird, während jeder Drehung der Scheibe für eine gegebene Implantation.

9. Verfahren nach Anspruch 7, wobei der Schritt der Steuerung der Geschwindigkeit ausgeführt wird durch Überwachung der Ladung während des zweiten Zeitintervalls entsprechend der Zeit die erforderlich ist, für den Strahl von einer Mitte eines ersten Wafers eine Überstreichung vorzunehmen und so dann über die zweiten und dritten Wafer beabstandet durch das nicht gleichförmige Abstandsintervall hinweg zu einer Mitte eines vierten Wafers und Überwachen der Ladung während des ersten Zeitintervalls entsprechend der Zeit die erforderlich ist, für den Strahl über die Mitten der zweiten und dritten Wafer hinwegzustreichen und Berechnen eines Wertes von $(3Q_1-Q_3)/2$, wobei der Wert $Q_1$ eine Ladung ist, die auf den Sensor während des ersten Zeitintervalls auftrifft und wobei der Wert $Q_3$ eine Ladung ist, die auf den Sensor während des zweiten Zeitintervalls auftrifft, und Machen bzw. Vorsehen der augenblicklichen Geschwindigkeit proportional zu dieser Größe und umgekehrt proportional zu einem Abstand zwischen einer Drehachse des Trägers (15) und einer Kontaktregion zwischen dem Ionenstrahl und den am Träger (15) angebrachten Wafern.

10. Träger (15) zur Verwendung in einem Ionenimplantationssystem zum Tragen von Wafern, wobei der Träger eine Vielzahl von sich radial erstrekkenden Waferbefestigungs- oder Anbringungsteilen (15a) aufweist, zum Tragen der Wafer an umfangsmäßig beabstandeten Intervallen um den Umfang des Trägers (15) herum, **dadurch gekennzeichnet, daß** der Winkel zwischen den Mitten eines Paares von benachbarten Waferanbringungsteilen (15a) bezüglich der Mitte des Trägers (15) unterschiedlich ist vom Winkel zwischen den Mitten der anderen Paare von benachbarten Waferanbringungsteilen (15a) bezüglich der Mitte des Trägers (15).

## Revendications

1. Un appareil destiné à être utilisé dans un système d'implantation ionique comportant une source d'ions pour guider un faisceau ionique (10) de façon qu'il pénètre dans une chambre d'implantation (13) pour implanter les ions dans des tranches, comprenant:

un support (15) conçu pour être positionné à l'intérieur de la chambre d'implantation, le support (15) comprenant une pluralité de pièces de montage de tranche circonférentiellement espacées pour porter des tranches à des intervalles circonférentiellement espacés autour de la circonférence dudit support (15), le support étant construit de telle sorte qu'il existe un intervalle d'espacement entre au moins deux pièces de montage adjacentes (15a) qui n'est pas uniforme par rapport à un intervalle d'espacement entre d'autres paires de pièces de montage adjacentes (15a) situées en d'autres emplacements autour de la circonférence;

un moteur (16) pour entraîner le support (15) en rotation autour d'un axe de rotation par rapport au faisceau ionique qui pénètre dans la chambre d'implantation pour provoquer l'interception par les tranches du faisceau ionique;

un détecteur (20) disposé derrière le support pour contrôler le courant de faisceau ionique pénétrant dans la chambre d'implantation qui passe au-delà du support (15) et des tranches montées sur lui;

un dispositif de balayage (17) pour déplacer le support (15) suivant un trajet de déplacement de façon que la totalité de la surface des tranches montées sur le support (15) soi traitée par le faisceau ionique; et

un circuit de commande (22) pour commander le déplacement du support (15) suivant le trajet de déplacement comprenant un circuit pour contrôler le courant de faisceau pendant deux intervalles de temps différents qui comprennent un premier intervalle de temps au cours duquel le faisceau ionique passe à travers l'intervalle d'espacement non uniforme et un second intervalle de temps au cours duquel le faisceau ionique passe à travers un intervalle d'espacement autre que l'intervalle d'espacement non uniforme, pour déterminer la charge atteignant le détecteur pendant les deux intervalles de temps et pour commander la vitesse de déplacement du support le long du trajet de déplacement sur la base de la charge détectée pendant les deux intervalles de temps différents.

2. L'appareil de la revendication 1, dans lequel le circuit de commande (22) met à jour la vitesse de déplacement le long du trajet de déplacement lors de chaque tour du support.

3. L'appareil de la revendication 1, dans lequel le circuit servant à contrôler le courant de faisceau comporte un circuit de codage (212) pour contrôler la rotation du support et pour produire des signaux de synchronisation fonction de l'orientation du support et comporte, en outre, des premier et second circuits de minutage (220; 222) fonctionnant en réponse au circuit de codage pour déterminer la charge pendant les deux intervalles de temps.

4. L'appareil de la revendication 1, dans lequel le dispositif de balayage (17) comprend un moteur électrique réversible et un actionneur linéaire accouplé au support pour déplacer le support suivant un trajet de déplacement linéaire.

5. L'appareil de la revendication 3, dans lequel le circuit de commande (22) comprend des moyens pour calculer une vitesse instantanée suivant le trajet de déplacement qui est directement proportionnelle à une valeur calculée laquelle est indépendante d'une distance R entre l'axe de rotation du support et une région de contact entre le faisceau ionique et les tranches montées sur le support.

6. L'appareil de la revendication 5, dans lequel le second intervalle de temps correspond au temps mis par le faisceau pour effectuer un balayage à partir du centre d'une première pièce de montage puis sur des seconde et troisième pièces de montage espacées l'une de l'autre de l'intervalle d'espacement non uniforme jusqu'au centre d'une quatrième pièce de montage de tranche, et dans lequel le premier intervalle de temps correspond au temps mis par le faisceau pour effectuer un balayage entre les centres des seconde et troisième pièces de montage et dans lequel la valeur calculée est égale à la quantité $(3Q1 - Q3)/2$, formule dans laquelle la valeur Q1 est une charge qui frappe le détecteur pendant le premier intervalle de temps et la valeur Q3 est une charge qui frappe le détecteur (20) pendant le second intervalle de temps desdits deux intervalles de temps différents.

7. Un procédé destiné à être utilisé avec un système d'implantation ionique comportant une source pour guider un faisceau ionique (10) de façon qu'il pénètre dans une chambre d'implantation (13) pour implanter les ions dans des tranches (25), comprenant les étapes qui consistent:

à positionner une pluralité de tranche à des intervalles espacés autour de la circonférence d'un support (15) disposé à l'intérieur de la chambre d'implantation de telle sorte qu'il existe au moins un intervalle d'espacement entre deux pièces de montage adjacentes qui n'est pas uniforme par rapport à un intervalle d'espacement entre d'autres paires de pièces de montage adjacentes situées en d'autres emplacements autour de la circonférence;

à entraîner le support (15) en rotation autour d'un axe de rotation par rapport au faisceau ionique qui pénètre dans la chambre d'implantation pour provoquer le passage des tranches dans le faisceau ionique;

à positionner un détecteur (20) servant à contrôler le courant de faisceau ionique derrière le support (15) pour contrôler le courant de faisceau ionique qui passe dans les espaces entre les tranches;

à monter le support (15) de façon qu'il puisse se déplacer suivant un trajet de déplacement de manière que la totalité de la surface des tranches montées sur le support (15) soit traitée par le faisceau ionique; et

à commander le déplacement du support (15) suivant le trajet de déplacement en contrôlant le courant de faisceau pendant deux intervalles de temps différents qui comprennent un premier intervalle de temps au cours duquel le faisceau ionique passe à travers l'intervalle d'espacement non uniforme et un second intervalle de temps au cours duquel le faisceau ionique passe à travers un intervalle d'espacement autre que l'intervalle d'espacement non uniforme, à déterminer la charge atteignant le détecteur pendant les deux intervalles de temps et à commander la vitesse de déplacement du support le long du trajet de déplacement sur la base de la charge détectée pendant les deux intervalles de temps différents.

8.  Le procédé de la revendication 7, dans lequel l'étape de contrôle du courant de faisceau et de détermination de la charge qui atteint le détecteur (20) pendant les deux intervalles de temps différents est effectuée lors de chaque tour du support.

9.  Le procédé de la revendication 7, dans lequel l'étape de commande de la vitesse est effectuée en contrôlant la charge pendant le second intervalle de temps correspondant au temps mis par le faisceau pour effectuer un balayage à partir du centre d'une première pièce de montage puis sur de seconde et troisième pièces de montage séparées l'une de l'autre de l'intervalle d'espacement non uniforme jusqu'au centre d'une quatrième pièce de montage de tranche, et en contrôlant la charge pendant le premier intervalle de temps correspondant au temps mis par le faisceau pour effectuer un balayage entre les centres des seconde et troisième tranches et en calculant une valeur (3Q1 -Q3)/2, formule dans laquelle la valeur Q1 est une charge qui frappe le détecteur pendant le premier intervalle de temps et la valeur Q3 est une charge qui frappe le détecteur pendant le second intervalle de temps et en rendant la vitesse instantanée proportionnelle à cette quantité et inversement proportionnelle à une distance entre un axe de rotation du support (15) et une région de contact entre le faisceau ionique et les tranches montées sur le support (15).

10. Un support (15) destiné à être utilisé dans un système d'implantation ionique pour porter des tranches, le support comprenant une pluralité de pièces de montage s'étendant radialement (15a) servant à porter des tranches à des intervalles circonférentiellement espacés autour de la circonférence du support (15), **caractérisé en ce que** l'angle entre les centres de deux pièces de montage adjacentes (15a) par rapport au centre du support (15) est différent de l'angle entre les centres d'autres paires de pièces de montage de tranche adjacentes (15a) par rapport au centre du support (15).

EP 0 686 995 B1

**Fig.1**

12
10
13
20
16
22
17
15

**Fig.2**

1  A+B  2
151  B  A
152  3
167  153
166  154
165  15b
155
R
15a
156
164
157
163
158
162  159
161  160

Fig.3    Fig.4

Fig.5

Fig.6

EP 0 686 995 B1

Fig.7A

Fig.7B

Fig.8

Fig:9

Fig.10